# EUROPEAN PATENT APPLICATION

(11) **EP 4 447 627 A1**
(43) Date of publication of application: **16.10.2024**
(21) Application number: 23167363.3
(22) Date of filing: 11.04.2023
(51) Int. Cl.: H05K 7/20

(54) **TWO-PHASE IMMERSION COOLING OF ELECTRONIC COMPONENTS**

(71) Applicant: Coincidence UG (haftungsbeschränkt), 78048 Villingen-Schwenningen (DE)
(72) Inventor: Kempa, Tim, 78048 Villingen-Schwenningen (DE)
(74) Representative: Meyer zu Bexten, Elmar

(57) **Abstract**

Heat pump system, comprising:
- a vaporizable two phase fluid having a liquid phase and a gas phase, the boiling point being within an operating temperature range of a system to be cooled and at least the liquid phase of said vaporizable two phase fluid being in heat contact with said system to be cooled,
- a pump system adapted to increase the pressure on the vaporized fluid
- a fluid guiding system adapted to guide the vaporized fluid from the pump to a condensing position being in heat contact to an external heat reservoir and being adapted to allow for condensing vaporized fluid into liquid fluid
- a fluid guiding system adapted to guide the liquid fluid back to the system to be cooled
- a pressure reduction system adapted to reduce pressure of the liquid when in heat contact to the system to be cooled.

## Description

This invention relates to the field of two phase immersion cooling of electronic components.

When cooling electronic components and/or more complex electronic systems like computers in general or especially computer servers, vaporization of liquids may be used.

One prominent example are computer servers applied for banking applications in general and/or special banking applications involving any hardware, software or special transactions related to so called "bitcoin mining" and/or so called "Proof-of-work systems" as commonly known to bankers and/or banking software specialists, especially when involved in bitcoin transactions.

A liquid having a boiling point in a range of 20°C to 150°C, or more specifically in a range of 30°C to 100°C, or even more specifically in a range of 30°C to 70°C, is set into heat contact with the electronic components to be cooled.

The term "boiling point", as used herein, usually refers to a fix boiling point at a certain pressure. This means that the boiling point may vary as a function of pressure, but has a fixed value if the pressure is fixed.

One particular example of a fluid to be used is "3M^{™} Novec^{™} 7000 Engineered Fluid" (https://www.3m.com/3M/en_US/p/d/b5005006004/) having a boiling point of 34 °C (@1bar).

One practical example of the working temperature of hardware to be cooled is about 30 to 70°C, as specified by one hardware supplier.

Although not necessary in all cases, the electronic components to be cooled may even be immersed within this liquid and often will.

The vaporization process absorbs heat from the electronic components to be cooled. Convection of ascending bubbles created by vaporizing of liquid at the warm component is generally sufficient to cool the components.

In condensing, the originally absorbed heat is set free again, so that in summary the originally absorbed heat is transferred to the heat reservoir and the vapor is returned to the liquid phase such that the fluid cycle is closed as well.

By means of condensers, the created vapor is usually condensed to liquid again within the same container and cooled down again.

This procedure, as presently used in bigger computational centers, is elaborate, expensive and further wastes a high amount of energy. The heat produced by the electronic components is wasted. The cooling means applied to cool down the vapor and liquid waste further energy.

It is therefore the goal of the present invention, to provide means and/or procedures avoiding these disadvantages of the present art.

To this end, the vapor created in absorbing heat from the electronic components to be cooled, is not condensed immediately, but is used for a heat pump fluid circuit.

By means of a pump, the vapor is at first compressed adiabatically in order to reach a higher pressure. In doing so, it's temperature is further increased at the same time.

The vapor is then condensed within a condenser in heat contact with some heat reservoir. For example, the condensers may be situated within a water tank being part of a house heating installation or some industrial heating plant.

The condensed liquid then passes via a throttle or similar means and is conducted back to its first place in heat contact with the electronic components to be cooled. Thereby, the fluid cycle is closed.

Usually some proper kind of tubing means in a closed circle is used for guiding vapor or liquid cooling fluid between the electronic components to be cooled and the condenser(s), keep it separated from the environment and allow for heat contact with the "outside world" only where intended and needed.

Thereby, the following advantages are reached:
The electric energy applied is primarily used for operating electronic components instead of simply transferring it into heat energy.

A highly efficient cooling of electronic components is obtained. Typical electronic components to be cooled are for example computer servers or Bitcoin-Mining equipment.

Heat transfer losses due to heat transfer between different fluid circuits are avoided.

As compared to existing heat pumps, considerably higher temperature levels are reached.

The system doesn't need much maintainance and works in a closed circuit.

As compared to other cooling fluids used for electronic components, two phase immersion fluids are non-flammable, clean and environmentally friendly.

The invention can be applied to cooling processes in air conditioning systems as well.

To this end, the gas being subject to high pressure is first cooled down and then expanded afterwards.

The efficiency of compression and condensation might be additionally increased by using a pressure tight container, such that the vaporization additionally increases pressure. Thereby, condensation and subsequent compression would be more efficient.

The container should be pressure tight and thermally insulated.

If also the employed power supplies are immersed in the liquid within the containers, an additional efficiency increase might be reached. In doing so, the energy of their heat losses due to rectifying the alternating voltage might be collected as well.

It should further be noted that the hardware can simply be exchanged. Therefore, the cooling/heating system does not have to be changed, but can be optimized by using more efficient computer hardware and/or mining hardware.

Within this text, a number of technical terms is repeatedly used.

A fluid medium indicates a medium which is able to flow, as for example a liquid or a gas. It therefore is not shape-resistant.

A two phase medium is a fluid which is able to exist in one of two different phases like for example a gaseous or a liquid phase.

Within the context of this invention, the term two phase medium is used almost synonymous to a vaporizable two phase fluid, wherein the transition from liquid phase to gas phase is called vaporization, usually involves a substantial uptake of heat energy, and usually occurs at a quite precise temperature called the boiling point.

Therefore, the gas resulting from vaporization of the liquid form may be called vaporized fluid.

Condensing means transferring vaporized fluid back into liquid form, and usually involves a substantial release of heat energy.

So a change of phase usually needs a heat transfer. A heat uptake is regularly needed in order to attain vaporization of the fluid. On the other hand, when the medium condenses, heat is set free.

The fluid therefore has to be in heat contact with the external world. While in its liquid form, it is in heat contact with a system to be cooled at a first position. The fluid is vaporized while taking up heat from the system to be cooled. The vaporized fluid then is guided to a second position, at which it is in heat contact to an external heat reservoir, like for example a water tank, to which a substantial amount of heat is transferred, while the vaporized fluid is condensed into a liquid again.

Heat transfer in itself is possible without phase change of course. But usually, in heat pump applications, a phase change is welcome, because the amount of heat involved in vaporizing a fluid, especially for example a dielectric fluid, may be huge.

The term dielectric fluid generally means a fluid that is not conductive. Within the context of this invention, it is helpful to choose a dielectric fluid as the cooling fluid since in this case, any direct contact of the fluid and any electric components, as for example electronic components to be cooled does not harm these components. If a non-dielectric fluid is chosen as the cooling means, any direct contact between the cooling fluid and the parts to be cooled has to be avoided carefully. Using a dielectric fluid as the cooling fluid, it is even possible to immerse the electronic components to be cooled completely in the cooling fluid, thereby obtaining a considerably better heat contact.

Further, within the context of this invention, strong intermolecular bounds in a liquid are interesting in that they usually imply a somewhat high boiling point since more heat is needed to break up intermolecular bounds than if these bounds would be less strong. It is especially interesting to be able to choose a fluid according to its boiling point such that the boiling point is within a certain predefined temperature range where cooling is intended to be highly effective.

For example, if it is intended to cool electronic components having a maximum operating temperature of about 80°C, and for which therefore an operating temperature range of 30° to 70° should be secured, a cooling fluid having a boiling point in the range of 30° to 70° would be chosen.

As stated above, the term " boiling point" here is to be understood as a fix boiling point at certain pressure, like "3M^{™} Novec^{™} 7000 Engineered Fluid" (https:/Iwww.3m.com/3M/en_US/p/d/b5005006004/) having a boiling point of 34 °C (@1bar), as stated above.

A fluid guiding system is needed in both cases, respectively. So, a first tubing system is needed in order to guide vaporized fluid from the first heat transfer position, in which it is vaporized, to the second heat transfer position, where it is condensed to liquid again. And a second tubing system is needed in order to guide condensed liquid back to the first heat transfer position such that the fluid circuit is closed and the fluid can be re-used for the next "vaporization cycle".

It will be clear to anyone of average skills in the art, that overall, a closed fluid circuit is needed. A closed circuit is needed in order to re-use the fluid and obtain a cylic heat transfer process overall. The tubing must further allow for pressure control, which also implies a substantially gas-tight container and tubing system.

It will be clear as well, that further components might be additionally included within this fluid cycle.

For example, a diffuser or throttle might be included "on the way back" between condenser and first heat transfer position (cooling position) in order to reduce pressure explicitly at some definite position within the fluid cycle. This is usually done such that vaporization takes place explicitly at the point where heat shall be absorbed, for example from electronic components to be cooled.

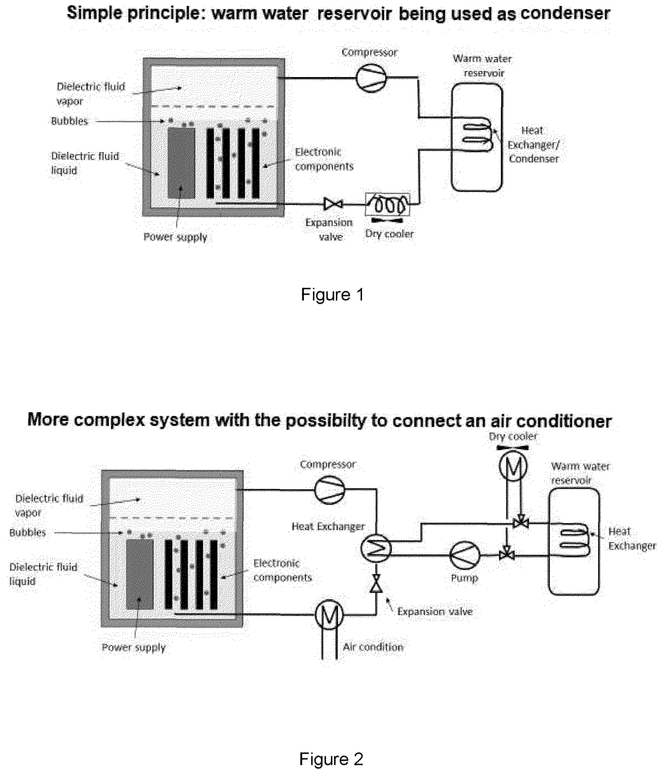

Figure 1 shows a simple embodiment of the invention.

Within a sealed container, the electronic components are immersed within the dielectric fluid in its liquid phase.

In this example, as shown in the figure, also the power supply is immersed within the dielectric fluid, which may or may not be the case.

In cooling the electronic components, and thereby taking up heat, liquid phase dielectric fluid is vaporized. This can be seen in the figure in form of bubbles being built.

Dielectric fluid vapor collects in the upper part of the container, above the surface of the liquid phase in which the electronic components are immersed.

Via some tubing, the vapor is then guided to a compressor, where it's pressure is increased, and further to a heat exchanger and condenser, being in heat contact with a water tank, in order to accept the excess heat of the compressed vapor.

At the same time, this allows the vapor to condense into the liquid phase again.

The liquid is then further guided via an additional dry cooler and an expansion valve to finally allow reduction of pressure again before the liquid is returned into the container in the lower part thereof. The fluid cycle is closed.

Figure 2 shows a more complex embodiment of the invention.

Several parts are similar to the embodiment shown in figure 1. Therefore, only the deviations of figure 1 will be described in detail.

In this embodiment, actually two fluid cycles are applied. Vaporized dielectric fluid is again compressed by a compressor and guided to a first heat exchanger shown in the middle of the figure. It then further passes through an expansion valve and an air conditioning system before it is returned to the lower part of the container to close the first cooling fluid cycle, being in direct contact with the electronic components to be cooled.

As shown in the right part of figure 2, the first heat exchanger transfers heat to a second closed fluid cycle including two dry cooler stages as well as a pump and a heat exchange within a water tank, arranged in the manner shown in the figure.

This arrangement therefore not only allows for heat transfer to the water tank, but further includes an air conditioning stage.

## Claims

1. Heat pump system, comprising:
- a vaporizable two phase fluid having a liquid phase and a gas phase, the boiling point being within an operating temperature range of a system to be cooled and at least the liquid phase of said vaporizable two phase fluid being in heat contact with said system to be cooled,
- a pump system adapted to increase the pressure on the vaporized fluid
- a fluid guiding system adapted to guide the vaporized fluid from the pump to a condensing position being in heat contact to an external heat reservoir and being adapted to allow for condensing vaporized fluid into liquid fluid
- a fluid guiding system adapted to guide the liquid fluid back to the system to be cooled
- a pressure reduction system adapted to reduce pressure of the liquid when in heat contact to the system to be cooled.

2. Heat pump system, according to claim 1,
wherein the fluid is a dielectric fluid.

3. Heat pump system, according to claim 1 or 2,
wherein the fluid has strong intermolcular bounds.

4. Heat pump system, according to any of the preceding claims,
wherein the system to be cooled is an electronic component.

5. Heat pump system, according to claim 4,
wherein the electronic component is part, such as a motherboard or power unit, of a computer, preferably a computer server, for example, being used for banking applications or bitcoin mining.

6. Heat pump system according to any of the preceding claims,
wherein the boiling point of the liquid fluid is within an operating temperature range of the system to be cooled, for example within the range of 20°C to 150°C, in particular within the range of 30°C to 100°C or especially within the range of 30°C to 70°C.

7. Heat pump system according to any of the preceding claims,
wherein the boiling point of the liquid fluid is 34 °C at 1 bar.

8. Heat pump system, according to any of the preceding claims,
wherein the external heat reservoir is part of a heating installation, for example an industrial heating installation or an air-conditioning system.

9. Heat pump procedure, wherein
- a vaporizable two phase fluid having a liquid phase and a gas phase, and having a boiling point within a predefined temperature range, is brought into heat contact with a system to be cooled at a first heat contact position, whereby part of the liquid phase of the two phase fluid is vaporized and thereby absorbs part of the heat of the system to be cooled,
- a pump system is applied to further increase the pressure of the gas phase of the vaporized fluid after it leaves the first heat contact position
- a first fluid guiding system is used to guide the vaporized fluid from the first heat contact position to a second heat contact position being in heat contact with an external heat reservoir and being adapted to allow for condensing vaporized fluid into liquid fluid
- a second fluid guiding system adapted to guide the liquid fluid back to a diffusor system adapted to reduce pressure of the liquid and guide the liquid fluid further back to the first heat contact position being in heat contact with the system to be cooled, such that the fluid circle is closed and heat is transferred from the first heat contact position to the second heat contact position.

10. Heat pump procedure according to claim 9,
wherein the system to be cooled is an electronic component.

11. Heat pump procedure according to claim 9 or 10,
wherein the electronic component is part, such as a motherboard or power unit, of a computer, preferably a computer server, for example, being used for banking applications or bitcoin mining.

12. Heat pump procedure according to any of claims 9 to 11,
wherein the boiling point of the liquid fluid is within an operating temperature range of the system to be cooled, for example within the range of 20°C to 150°C, in particular within the range of 30°C to 100°C or especially within the range of 30°C to 70°C.

13. Heat pump procedure according to any of claims 9 to 12,
wherein the boiling point of the liquid fluid is 34 °C at 1 bar.

14. Heat pump procedure according to any of claims 9 to 13,
wherein the external heat reservoir is part of a heating installation, for example an industrial heating installation or an air-conditioning system.
